# EUROPEAN PATENT APPLICATION

(11) **EP 1 202 330 A2**
(43) Date of publication of application: **02.05.2002**
(21) Application number: 01309017.0
(22) Date of filing: 24.10.2001
(51) Int. Cl.: H01L 21/00

(54) **De-coupled wafer lift and five axis adjustable heater lift system for CVD process chamber**

(30) Priority: 26.10.2000 US 698814
(71) Applicant: Applied Materials, Inc., Santa Clara, California 95054 (US)
(72) Inventor: Schieve, Eric W., Palo Alto, CA 94306 (US); Koai, Keith K., Los Gatos, CA 95032 (US)
(74) Representative: Bayliss, Geoffrey Cyril

(57) **Abstract**

Provided herein is a de-coupled wafer lift and heater lift system for CVD process chamber (101). This de-coupled lift system comprises a heater lift (104) and a wafer lift (106). The heater lift contains a clamping block (103), which has an integrated clamping flexure arm (113); and a yoke (105), which has clamping screws and clamp surface. The yoke (105) is inserted into the block. The wafer lift contains a keyed lift hoop (110); lift pins (111) oriented substantially perpendicular to the hoop; and a keyed bellows shaft. The keyed lift hoop (110) and keyed shaft bellows (108) are coupled using a single clamping screw.

## Description

The present invention relates generally to the field of semiconductor manufacturing. More specifically, the present invention relates to a de-coupled wafer lift and five axis adjustable heater lift for a chemical vapor deposition process chamber.

Physical vapor deposition (PVD), chemical vapor deposition (CVD) and etch chambers commonly use a heated wafer (or other substrate) support or pedestal, on which the wafer (or other substrate) is mounted, to enable control of substrate temperature during processing. To ensure predictable heat transfer between the wafer and the support, the wafer must make uniform and stable (non-moving) contact with the support, yet be readily placed and removed from the support surface. Heat is typically provided by the placement of an electric resistance wire heater in contact with the underside of the wafer support.

Existing heater/wafer lift mechanisms reside primarily on 200 mm wafer processing platforms. These lifts traditionally have been configured as compound mechanisms with both the heater lift and wafer lift concentrically configured with a single drive motor actuating both lifts. In this traditional design each lift's movement is determined by fixed hard stops placed at precise locations along a column. Motion of each lift is confined to predetermined mechanical arrangement and cannot be easily adapted to varying component changes such as heater lengths or wafer pin lengths. The flexibility of these lifts is limited to the specific chamber and process kit for which it is designed.

The transition from 200 mm to 300 mm chamber sizes has provided the opportunity to introduce a de-coupled lift where the motion of the heater and wafer lifts are independent of one another. Each lift is actuated using its own independent drive motor. Coordinated motion of each lift is now achieved by controlling these drive motors with software routines. These software routines allow the user to define each lift's motion profile independently to meet a variety of different chamber dimension constraints (heater lengths, wafer pin lengths, chamber depths, etc.). The wafer handling system in the chamber is no longer constrained by fixed mechanical hard stops applied in a narrow set of applications.

The cross platform flexibility of the de-coupled lift allows one to standardize around a single mechanism enabling potential economic benefits in terms of reduction of parts per lift, creation of standard cross platform serviceability procedures and a reduction in the number of wafer lift system styles requiring cumbersome inventory burdens.

For wafer lift designs, aluminum sleeve and stainless steel shafts are currently available. However, the aluminum sleeve is retained on the mating shaft by two horizontally oriented set screws that are difficult to access. Additionally, as the aluminum sleeve and stainless steel shaft heat up under process conditions, the aluminum sleeve expands at a greater rate than the stainless steel shaft causing the sleeve to lose contact with the shaft. Without frictional contact the set screws become pivot points that can allow side-to-side vibration during vertical motion.

Therefore, the prior art is deficient in the lack of effective implementation of a de-coupled wafer lift and heater lift mechanism for use in chemical vapor deposition process chambers. The present invention fulfills this long-standing need and desire in the art.

An aspect of the present invention, provided herein, is an implementation of decoupled wafer lift and heater lift mechanism for use in chemical vapor deposition process chambers. This de-coupled lift system comprises a heater lift and a wafer lift.

The heater lift is composed of two mating components: a clamping block and a yoke. The clamping block is a monolithic structure with a clamping flexure arm integrated into the structure's body. The clamping block provides a horizontal gravitationally referenced clamping surface. The yoke provides a similar horizontal gravitationally referenced clamping surface as the clamping block. The yoke utilizes clamping components mated to the main yoke body by clamping screws. The yoke is inserted into the clamping block through the clamping block's flexure arm.

The wafer lift contains a keyed lift hoop, lift pins oriented substantially perpendicular to the hoop, and a keyed bellows shaft. The keyed lift hoop and keyed bellows shaft are coupled by a single set of clamping screws. The lift pins are oriented vertically and guided by sleeves in the heater body and move up and down by contacting the horizontal surface of the hoop.

Another aspect of the present invention, provided herein, is a method of processing a substrate in a CVD process chamber using the de-coupled wafer lift and heater lift described above. In this method, the heater is oriented in the process chamber using the heater lift. The substrate is brought into the chamber and oriented relative to the heater via an extended mainframe system robot arm and blade. The wafer lift pushes the pins up until the substrate is removed from the robot blade. The robot arm and blade are then retracted from the chamber. Finally, the wafer lift is lowered allowing the pins to place the substrate on the heater for subsequent processing.

Other and further aspects, features, and advantages of the present invention will be apparent from the following description of the embodiments of the invention given for the purpose of disclosure.

So that the matter in which the above-recited features, advantages and objects of the invention, as well as others which will become clear, are attained and can be understood in detail, more particular descriptions of the invention briefly summarized above may be had by reference to certain embodiments thereof which are illustrated in the appended drawings. These drawings form a part of the specification. It is to be noted, however, that the appended drawings illustrate embodiments of the invention and therefore are not to be considered limiting in their scope.

**Figure 1** is a cross-sectional view of the de-coupled wafer lift and five axis adjustable heater lift system in accordance with the present invention. Shown here are chamber body **101,** chamber lid and face plate **102,** yoke block **103,** heater lift mechanism **104,** yoke **105,** pin lift mechanism **106,** gimbal (heater base) **107,** bellows shaft **108,** heater **109,** keyed hoop **110,** pin **111,** and wafer **112.**

**Figures 2A-2C** depicts various views of the clamping block and yoke. **Figure 2A** is an isometric view showing yoke **105** with vertically oriented clamping screws, yoke block **103** with clamping flexure and vertically accessible clamping screw, and gimbal (heater base) clamp **107. Figure 2B** is a side view of the clamping block and yoke showing the clamping flexure **113. Figure 2C** is a bottom view showing slotted hole **114** for clamping screw.

**Figure 3** shows an isometric view of keyed hoop bellows shaft. Specifically shown here is keyed hoop feature **110.**

**Figure 4** shows an isometric view of shielded bellows showing internal bellows shield **115.**

**Figure 5** shows a three-dimensional view of the de-coupled wafer lift and five axis adjustable heater lift system in accordance with one embodiment of the present invention.

**Figure 6** shows an isometric top view of the lift components with the chamber body present.

**Figure 7** shows an isometric top view of the lift components without the chamber body present.

**Figure 8** shows the translational and rotation axes oriented about the physical axes of the lift components. These axes represent the degrees of freedom the heater must move in to achieve level and center orientation relative to the process chamber shower head.

**Figure 9** is an exploded view of the keyed hoop showing the hoop and shaft mating orientation.

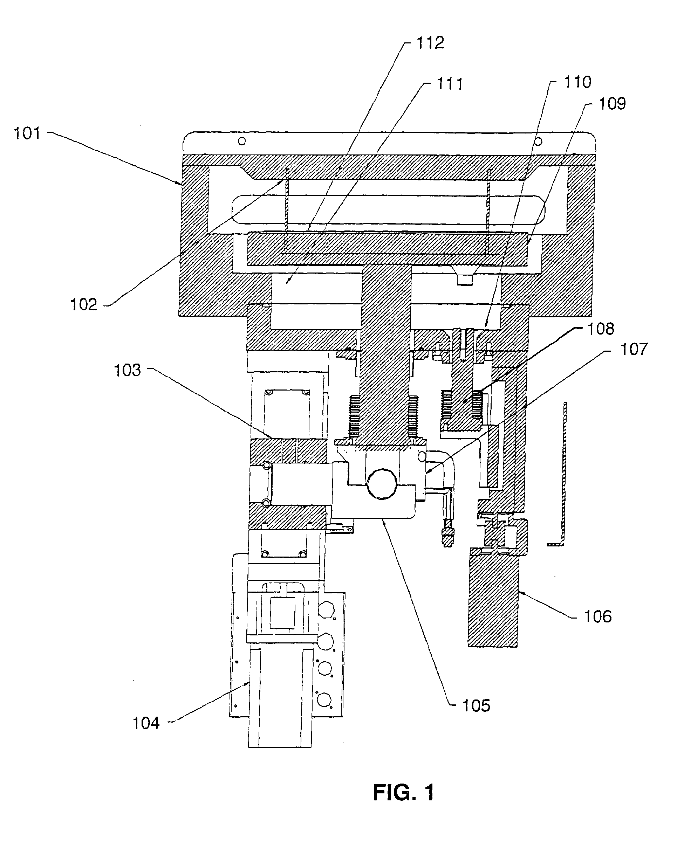

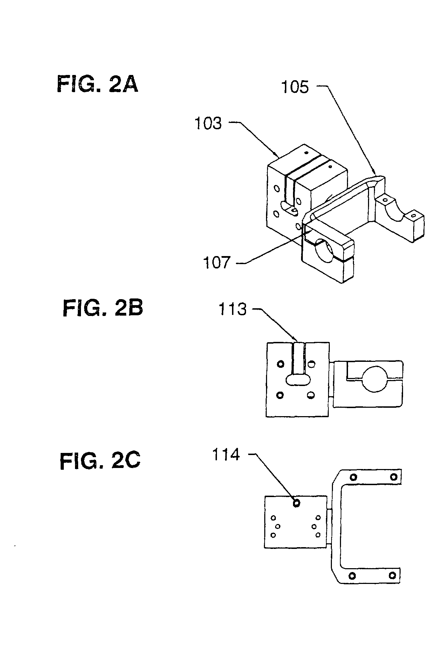

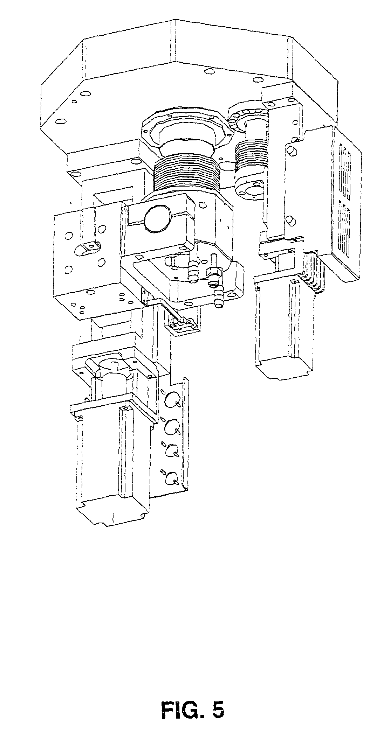

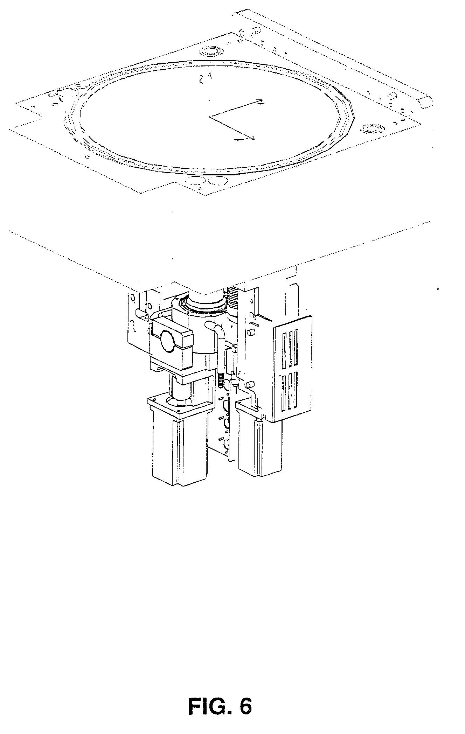

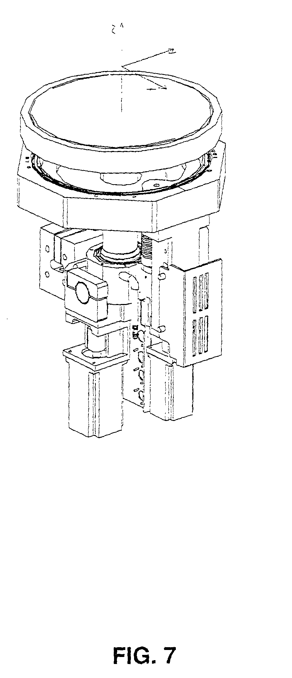

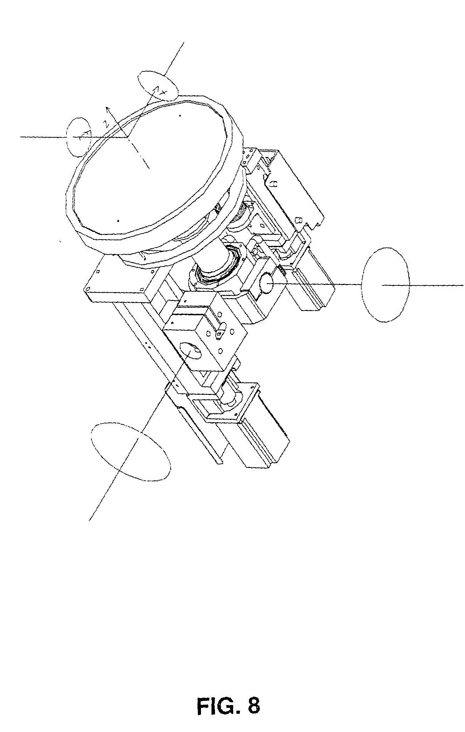

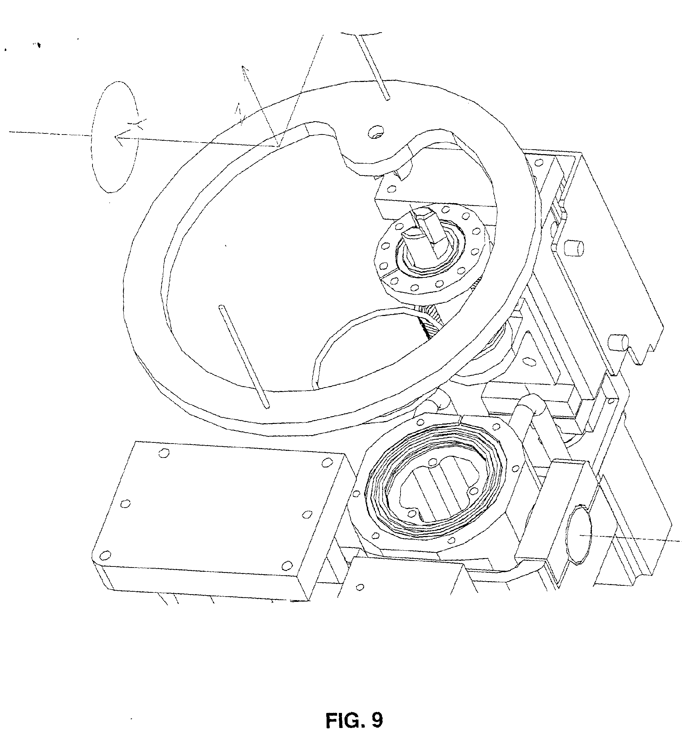

Provided herein is a de-coupled wafer lift and five axis adjustable heater lift system for chemical vapor deposition. The accompanying cross-sectional view illustrates the physical appearance of the main components (Figure 1), including chamber body **101,** chamber lid and face plate **102,** yoke block **103,** heater lift mechanism **104,** yoke **105,** pin lift mechanism **106,** gimbal (heater base) **107,** bellows shaft **108,** heater **109,** keyed hoop **110,** pin **111,** and wafer **112.** Figure 5 shows the 3-dimensional view of the system. The heater lift mechanism **104** is configured using a standard linear lead screw and drive motor arrangement. Clamping block **103** is bolted to the lead screw carrier which moves up and down. The yoke **105** is inserted into the clamping block **103** and is able to rotate and move left to right within the block until the desired orientation is achieved (Figures 2A-2C). By tightening the block clamping screw 114, the yoke **105** is held in place by the clamp flexure which generates a significant amount of frictional holding force. The gimbal (heater base) **107** is allowed to rotate and move side-to-side within the yoke's horizontally oriented round clamping surfaces until the yoke clamping screws are tightened allowing the yoke clamps to apply significant frictional holding force to the gimbal's round ears. These components, including the lift mechanism, allow the heater to move in all planar X, Y and Z directions, as well as two rotational axes (five axes) (see Figures 6-9).

During operation, the heater **109** first places wafer **112** at specified distances from the face plate **102.** The wafer on the heater must be level to the face plate within 0.002 inches. The heater lift mechanism **104** then moves up and down in the Z-direction, while the pin lift mechanism **106** also moves up and down in Z-direction. When the heater lift **104** is down and the pin lift **106** is up, the wafer **112** sits on the pins off the heater **109.** When the heater lift **104** is up and the pin lift **106** is down, the wafer **112** sits on the heater **109.** The heater lift mechanism **104** provides rotational and linear positioning allowing the heater to be properly oriented to the fixed face during normal operation. Normal operation is taken to mean the combined function of the heater lift/pin lift mechanisms placing and removing the wafer on and off the heater and orienting the wafer to the face plate.

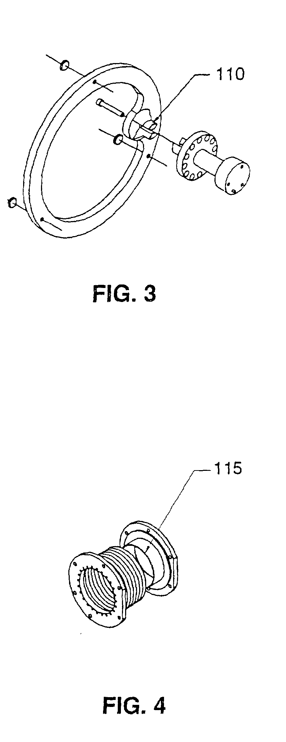

Other features included in this de-coupled wafer lift and five axis adjustable heater lift system are the keyed hoop bellows shaft and the shielded bellows. Keyed hoop **110** and keyed bellows shaft are shown in Figure 3. A single set screw connects these two components and is easily accessible during lift construction or maintenance. Both mating tolerances are tightly controlled so that the hoop and shaft key ways can thermally expand against one another at elevated process temperature providing a very rigid mounting scheme for the hoop, but have a nice slip fit at room temperatures. By minimizing side-to-side vibration of the hoop during vertical motion of the lift, the lift pins that ride along the hoop have less tendency to vibrate against their heater guide sleeves resulting in a smoother wafer motion.

The shielded bellows are illustrated in Figure 4. The inner shield **115** protects the bellows convolution when the heater is installed in the lift's upward process position. When the convolution is compressed, the bellows is shortened, allowing the shield to cover the convolutions and protect them from scraping or impact of the heater shaft during installation.

Compared to the conventional lift designs, the presently disclosed de-coupled wafer lift and five axis adjustable heater lift system has a number of novel features. First, the de-coupled lift system has a clamping block with vertical clamping flexure. The lift pivots upon a special clamping block that acts as an integrated platform and clamping mechanism designed to support the heater lift components that retain as well as allow orientation adjustment of the heater. A novel integrated flexure arm design provides a robust axially and rotationally adjustable platform for the heater yoke and gimbal (heater base) support components and generates tremendous clamping forces with minimal operator effort. The screw used in the clamping block that activates clamping is vertically accessible from the bottom giving clear access.

Secondly, the de-coupled lift system has a yoke with vertical clamping screws and serrated clamp surface. The yoke lift component provides a gravitationally oriented horizontal platform to support for the gimbal (heater base). This facilitates adjustment by providing a solid surface for the gimbal to rest on and vertically orients the clamping screw for clear accessibility from the bottom. Additionally, each clamp has a series of radial grooves that aids in gripping the stainless steel ears of the heater base when the clamping screws are tightened.

Thirdly, the unique gimbaled configuration in this de-coupled lift system opens new opportunities in implementing novel heater leveling and center techniques that are potentially more repeatable and less time consuming than current methods used in the compound mechanical lift.

Fourthly, the de-coupled lift system uses bellows with integrated protection shield. Specifically, bellows protection during heater installation is provided using a shielded bellows design that contains a protective tube welded internally to the bellows upper flange.

Fifthly, the de-coupled lift system uses unique keyed coupling between the lift hoop and bellows shaft. The wafer lift hoop is retained using a keyed design that requires a single set screw for assembly of the two components and is vertically accessible from the top facilitating assembly during manufacturing and disassembly during maintenance. This keyed design utilizes thermal expansion at elevated temperatures (200-300 degrees C) during process to create a press fit between two stainless steel keyed components. The press fit minimizes side-to-side vibration during vertical motion of the lift hoop. This keyed design replaces the current aluminum sleeve and stainless steel shaft design. The aluminum sleeve is retained by two horizontally oriented set screws that are difficult to access. Additionally as the aluminum sleeve and stainless steel shaft heat up under process conditions, the aluminum sleeve expands at a greater rate than the stainless steel shaft causing the sleeve to lose contact with the shaft. Without frictional contact the set screws become pivot points and can allow side-to-side vibration during vertical motion. The present keyed design also eliminates five screws and two clamps when compared to the sleeve version.

Lastly, the de-coupled lift system uses a closed ring wafer lift hoop with imbedded ceramic pads. The stainless steel hoop described in the keyed coupling bullet above has ceramic pads located at each pin site to improve durability of the hoop. Ceramic pads resist pitting caused by the frequent impact of the lift pin with the lifting hoop.

As described above, provided herein is a de-coupled wafer lift and heater lift system for chemical vapor deposition process chamber. This de-coupled lift system comprises a heater lift and a wafer lift. The heater lift contains a clamping block, which is a monolithic structure with a clamping flexure arm integrated into the structure's body; and a yoke, which has clamping screws and clamp surface. The yoke is inserted into the clamping block through the clamping block's flexure arm. The wafer lift contains a keyed lift hoop, lift pins oriented substantially perpendicular to the hoop, and a keyed bellows shaft. The keyed lift hoop and keyed bellows shaft are coupled by a single set of clamping screws. The lift pins are oriented vertically and guided by sleeves in the heater body and move up and down by contacting the horizontal surface of the hoop.

In this de-coupled lift system, the clamping block uses a vertically accessible clamping screw and acts as an integrated platform to support the heater lift components that retain as well as allow rotation adjustment of the heater, while the yoke provides a gravitationally oriented horizontal platform to support the heater base. The heater base can be de-coupled from the heater lift to perform leveling and centering procedures with devices and methods independent of lift mechanism. Once the heater is oriented properly, the lift can be reattached to maintain the heater's newly established orientation. Such heater lift moves the heater in planar X, Y, Z directions and two rotational axes (total 5 axes).

Also in this de-coupled lift system, the bellows shaft contains internal shielded bellows, wherein a tube is welded internally to the bellows upper flange. During processing, the coupled keyed lift hoop and bellows shaft expands at elevated temperatures to create a press fit between the keyed lift hoop and the keyed bellows shaft. Specifically, the elevated temperature is from about 200 degrees C to about 300 degrees C.

Additionally, the keyed lift hoop can be made of material like stainless steel, ceramic or aluminum, while the keyed bellows shaft is made of stainless steel. More specifically, the keyed lift hoop has imbedded ceramic pads at each pin site.

In another aspect, also provided herein is a method of processing a substrate in a CVD process chamber using the de-coupled wafer lift and heater lift described above. In this method, the heater is oriented in the process chamber using the heater lift, while the substrate is first brought into the chamber and oriented relative to the heater via an extended mainframe system robot arm and blade. The wafer lift pushes the pins up until the substrate is removed from the robot blade. The robot arm and blade are then retracted from the chamber. Finally, the wafer lift is lowered allowing the pins to place the substrate on the heater for subsequent processing. Specifically, the heater may be moved in planar X, Y, Z directions and two rotational axes during the orientation.

Further provided herein is that each lift component can be used as an assembly or as a separate component on other similar implementation for a lift configuration.

Any patents or publications mentioned in this specification are indicative of the levels of those skilled in the art to which the invention pertains. These patents and publications are herein incorporated by reference to the same extent as if each individual publication was specifically and individually indicated to be incorporated by reference.

One skilled in the art will readily appreciate that the present invention is well adapted to carry out the objects and obtain the ends and advantages mentioned, as well as those inherent therein. It will be apparent to those skilled in the art that various modifications and variations can be made in practicing the present invention without departing from the spirit or scope of the invention. Changes therein and other uses will occur to those skilled in the art which are encompassed within the spirit of the invention as defined by the scope of the claims.

## Claims

1. A de-coupled wafer lift and heater lift system for a chemical vapor deposition process chamber, comprising:
(1) a heater lift, comprising:
(a) a clamping block, wherein said block has an integrated clamping flexure arm; and
(b) a yoke, wherein said yoke has clamping screws and clamping surface, and wherein said yoke is inserted into said block; and
(2) a wafer lift, wherein said wafer lift is de-coupled from said heater lift, comprising:
(a) a keyed lift hoop;
(b) lift pins oriented substantially perpendicular to said hoop; and
(c) a keyed bellows shaft, wherein said hoop and shaft are coupled by a single clamping screw.

2. A de-coupled wafer lift and heater lift system as claimed in claim 1, wherein said heater lift moves the heater in planar X, Y, Z directions and two rotational axes.

3. A de-coupled wafer lift and heater lift system as claimed in claim 1 or claim 2, wherein said clamping block uses a vertically accessible clamping screw to actuate said integrated claming flexure arm.

4. A de-coupled wafer lift and heater lift system as claimed in any of claims 1 to claim 3, wherein said yoke provides a gravitationally oriented horizontal platform to support heater base.

5. A de-coupled wafer lift and heater lift system as claimed in any of claims 1 to 5, wherein said heater base can be de-coupled from the heater lift to perform leveling and centering procedures.

6. A de-coupled wafer lift and heater lift system as claimed in any of claims 1 to 5, wherein said bellows shaft comprises:
shielded bellows, wherein a tube is welded internally to the bellows upper flange.

7. A de-coupled wafer lift and heater lift system as claimed in any of claims 1 to 6, wherein the coupled keyed lift hoop and bellows shaft expands at elevated process temperatures to create a press fit between the keyed lift hoop and the keyed bellows shaft.

8. A de-coupled wafer lift and heater lift system as claimed in claim 7, wherein said process temperature is from about 200 degrees C to about 300 degrees C.

9. A de-coupled wafer lift and heater lift system as claimed in any of claims 1 to 8, wherein said keyed lift hoop is made of material selected from the group consisting of stainless steel, ceramic and aluminum.

10. A de-coupled wafer lift and heater lift system as claimed in any of claims 1 to 9, wherein said keyed bellows shaft is made of stainless steel.

11. A de-coupled wafer lift and heater lift system as claimed in any of claims 1 to 10, wherein said keyed lift hoop has imbedded pads at each pin site.

12. A de-coupled wafer lift and heater lift system as claimed in any of claims 1 to 11, wherein said pads are made of ceramic.

13. A method of processing a substrate in a chemical vapor deposition process chamber using the de-coupled wafer lift and heater lift system of claim 1, comprising the steps of:
orienting the heater in the process chamber using said heater lift;
loading a substrate in the process chamber using a robot;
orienting the substrate relative to the heater using said wafer lift; and
processing said substrate in said process chamber.

14. The method of claim 13, wherein the substrate loading and orienting steps further comprising:
lifting up the pins in the wafer lift to remove the substrate from the robot; and
lowering the wafer lift to allow the pins to place the substrate on the heater.

15. A method as claimed in claim 13 or claim 14, wherein said heater is moved by said heater lift in planar X, Y, Z directions and two rotational axes.

16. A lift configuration, comprising:
(a) a clamping block, wherein said block has an integrated clamping flexure arm; and
(b) a yoke, wherein said yoke has clamping screws and clamp surface, and wherein said yoke is inserted into said block.

17. A lift configuration as claimed in claim 16, wherein said clamping block uses a vertically accessible clamping screw to actuate said integrated claming flexure arm.

18. A lift configuration, comprising:
(a) a keyed lift hoop;
(b) lift pins oriented substantially perpendicular to said hoop; and
(c) a keyed bellows shaft, wherein said hoop and shaft are coupled by a single clamping screw.

19. A lift configuration as claimed in claim 18, wherein said bellows shaft comprising:
shielded bellows, wherein a tube is welded internally to the bellows upper flange.

20. A lift configuration as claimed in any of claims 18 or 19, wherein the coupled keyed lift hoop and bellows shaft expands at elevated temperatures to create a press fit between the keyed lift hoop and the keyed bellows shaft.

21. A lift configuration as claimed in any of claims 18 to 20, wherein said keyed lift hoop is made of material selected from the group consisting of stainless steel, ceramic and aluminum.

22. A lift configuration as claimed in any of claims 18 to 21, wherein said keyed bellows shaft is made of stainless steel.

23. A lift configuration as claimed in any of claims 18 to 22, wherein said keyed lift hoop has imbedded pads at each pin site.

24. A lift configuration as claimed in claim 23, wherein said pads are made of ceramic.
